# FASCICULE DE BREVET EUROPEEN

(11) **EP 0 905 907 B1**
(45) Date de publication et mention de la délivrance du brevet: **14.05.2003**
(21) Numéro de dépôt: 98402263.2
(22) Date de dépôt: 14.09.1998
(51) Int. Cl.: H03K 19/21, H03K 5/00

(54) **Porte logique OU-exclusif à quatre entrées complémentaires deux à deux et à deux sorties complémentaires, et multiplicateur de fréquence l'incorporant**
Exklusiv-Oder-Gatter mit vier zwei-zu-zwei komplementären Eingängen und zwei komplementären Ausgängen sowie Frequenzmultiplizierer damit
Exclusive OR gate with four two by two complementary inputs and two complementary outputs and frequency multiplier using the same

(30) Priorité: 25.09.1997 FR 9711956
(43) Date de publication de la demande: 31.03.1999
(73) Titulaire: STMicroelectronics S.A., 92120 Montrouge (FR)
(72) Inventeur: Marbot, Roland, 92593 Levallois-Perret Cedex (FR); Couteaux, Pascal, 92593 Levallois-Perret Cedex (FR)
(74) Mandataire: Ballot, Paul

(56) Documents cités:
- EP-A- 0 660 525
- US-A- 5 479 112
- "cmos differential cascode exclusive or/nor circuits" IBM TECHNICAL DISCLOSURE BULLETIN., vol. 30, no. 9, février 1988, pages 17-19, XP002065281 NEW YORK US
- PATENT ABSTRACTS OF JAPAN vol. 011, no. 161 (E-509), 23 mai 1987 & JP 61 294934 A (MITSUBISHI ELECTRIC CORP;OTHERS: 03), 25 décembre 1986
- PATENT ABSTRACTS OF JAPAN vol. 017, no. 542 (E-1441), 29 septembre 1993 & JP 05 152936 A (OKI ELECTRIC IND CO LTD), 18 juin 1993
- PATENT ABSTRACTS OF JAPAN vol. 006, no. 144 (E-122), 3 août 1982 & JP 57 065927 A (HITACHI LTD), 21 avril 1982

## Description

La présente invention concerne une porte logique OU-Exclusif à quatre entrées complémentaires deux à deux et à deux sorties complémentaires, ainsi qu'un multiplieur de fréquence l'incorporant.

Elle se rapporte au domaine de la conception de circuits intégrés pour le traitement et/ou la transmission de données numériques.

Elle s'applique notamment aux multiplieurs de fréquence utilisés pour la transmission de données numériques à haut débit par une liaison série, comme par exemple via une fibre optique.

On réalise actuellement de telles liaisons à des débits atteignant quelques gigabits par seconde. La bande passante des fibres monomodes couramment utilisées dans les systèmes de transmission optiques est suffisamment large pour que leur réponse ne distorde pas le signal. On constate en fait que c'est l'électronique dans l'émetteur et le récepteur qui constitue une limite à la vitesse de transmission des données. C'est le cas notamment des multiplieurs de fréquence compris dans l'émetteur. On sait réaliser un multiplieur comprenant une pluralité de portes OU-Exclusif à quatre entrées complémentaires deux à deux et à deux sorties complémentaires, disposées selon une structure en arbre. On pourra par exemple se référer au document EP-A-0 660 525. Un signal d'horloge périodique de fréquence fo, est transmis en entrée d'une chaîne de N circuits à retard disposés en série (N est préférentiellement une puissance entière de 2, tel que N = 2^{p}, avec p entier). On génère ainsi en sortie des circuits à retard des signaux périodiques de même fréquence fo successivement décalés dans le temps d'une durée égale à une fraction 1/N de la période 1/fo du signal d'horloge. Ce groupe de N signaux déphasés est équivalent à un unique signal d'horloge de fréquence Nxfo. On a ainsi réalisé une multiplication de fréquence du signal d'horloge par N. Ces N signaux sont utilisés pour échantillonner à la fréquence Nxfo chacun des N bits constituant un mot de données à transmettre en série, qui se présentent avec un débit donné. Les signaux constituant le résultat de ces opérations d'échantillonnage, et leurs complémentaires logiques, sont successivement transmis sur les couples d'entrées complémentaires d'au moins 2^{p-1} portes OU-Exclusif. Ces portes OU-Exclusif constituent la première couche de l'arbre. On veille à ne pas appliquer sur les deux couples d'entrées complémentaires d'une même porte des signaux échantillonnés par des signaux d'échantillonnage en phase ou en opposition de phase. On s'assure ainsi que les deux couples d'entrées complémentaires de la porte ne changent pas simultanément d'état logique. Chacune des couches suivantes comprend successivement la moitié moins de portes que la couche qui la précède, la dernière couche de l'arbre n'ayant qu'une porte. L'arbre comporte donc p couches de portes. Les signaux en sortie des portes d'une couche déterminée sont transmis en entrée des portes de la couche suivante de manière à ce que les deux couples d'entrées complémentaires de chaque porte ne reçoivent pas des couples de signaux complémentaires qui changent simultanément d'état logique. Les données numériques à transmettre sont alors disponibles en sortie de la porte de la dernière couche avec un débit N fois supérieur au débit initial.

On sait que pour limiter la distorsion du train de bits à transmettre, il convient de limiter la différence du temps de propagation de chacun des bits à travers l'arbre de portes OU-Exclusif. Or, avec la structure d'arbre décrite ci-dessus, chaque bit traverse un nombre identique de portes dans l'arbre. On peut en outre veiller à ce que la longueur des connexions entre les portes de deux couches successives de l'arbre soit identique afin que, quel que soit le chemin de propagation d'un front à travers l'arbre, la charge constituée par ces connexions soit identique.

Il reste donc à égaliser le temps de propagation d'un bit quelconque à travers chaque porte OU-Exclusif de l'arbre. Cela revient à rechercher une structure de porte OU-Exclusif qui présente un temps de propagation identique quelle que soit celui des deux couples d'entrées complémentaires qui commute, quel que soit la nature de la transition en sortie, et quel que soit l'état logique du couple d'entrées qui ne commute pas (et qui reste stable pendant la commutation). Par convention, une telle structure est, dans la suite, qualifiée de symétrique.

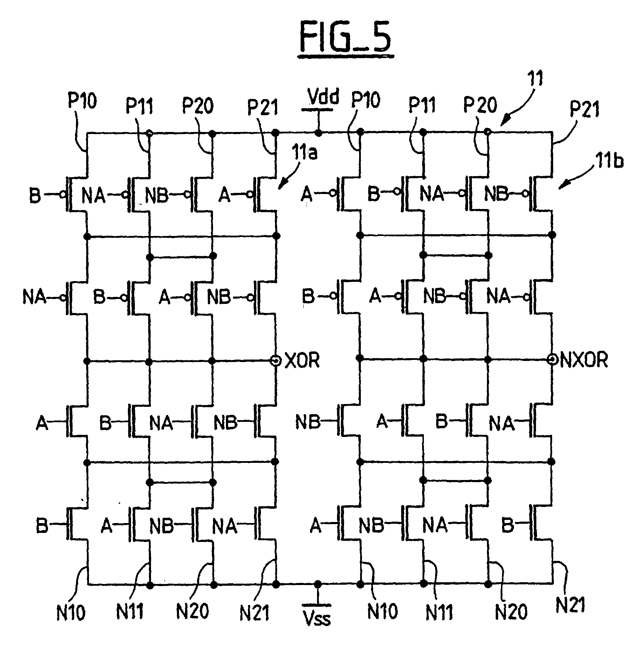

Le document EP-A-0 660 525 décrit une porte OU-Exclusif à quatre entrées complémentaires deux à deux et à deux sorties complémentaires que l'on peut qualifier de symétrique, selon la définition indiquée ci-dessus. La structure de la porte divulguée par ce document, qui sera décrite plus en détails dans la description qui va suivre (en référence notamment à la figure 4), vise à égaliser la charge appliquée à chacune des entrées, quel que soit l'état logique des autres entrées et quel que soit la nature de la transition en sortie de la porte.

Cependant, le document EP-A-0 660 525 indique que les temps de propagation des fronts dans un arbre comportant de telles portes OU-Exclusif n'ont été égalisés, grâce à cette structure de porte, qu'avec une précision de quelques dizaines de picosecondes. Cela signifie que, selon l'évolution dans le temps de la configuration des entrées de l'arbre, le front à propager se propage avec un temps de propagation qui peut varier avec une imprécision de cet ordre. En simulation, les inventeurs ont pu observer que cette imprécision est en fait de l'ordre de 70 picosecondes. Une telle valeur reste encore trop élevée pour parvenir à transmettre correctement des données sous forme série avec un débit élevé (de l'ordre de quelque gigabits par seconde). A plus forte raison si l'on cherche à augmenter encore la valeur du débit des données transmises.

Le but de la présente invention est de remédier à cet inconvénient. Plus précisément, l'invention vise à rechercher les causes possibles de la variation des temps de propagation des fronts à travers une porte OU-Exclusif du type de celle divulguée dans le document EP-A-0 660 525 et à proposer des moyens pour y remédier.

A cet effet, l'invention a tout d'abord consisté pour les inventeurs à se livrer à de longues et patientes analyses du comportement électrique de la porte OU-Exclusif selon l'art antérieur, dont le document EP-A-0 660 525 indique pourtant qu'elle est structurellement et fonctionnellement symétrique. L'analyse du comportement de cette porte, à la fois en régime statique et en régime dynamique, au sein d'une structure en arbre telle que décrite ci-dessus, a permis aux inventeurs de mettre en évidence la cause des différences constatées du temps de propagation des fronts selon l'évolution de l'état logique des entrées de l'arbre au cours du temps. En effet, il a pu être déduit des analyses effectuées que, en fonction de l'état logique des entrées de la porte OU-Exclusif, certains des noeuds du circuit de la porte peuvent être flottants. Selon l'évolution de l'état logique des entrées, ces noeuds sont tour à tour chargés à des potentiels déterminés et déchargés par les transistors MOS (de type P ou de type N) aux drains desquels ils sont raccordés, lorsque ces transistors sont conducteurs. Mais, lorsque ces noeuds sont raccordés aux drains de transistors qui restent non conducteurs pendant une certaine durée dépendant de l'évolution de l'état logique des entrées au cours du temps, ces noeuds sont susceptibles de se décharger de manière non contrôlée. Plus exactement, les capacités internes des transistors, et notamment la capacité drain-substrat qui est prépondérante, se déchargent du fait de courants de fuite. Il en résulte que, lorsqu'un front se propage ultérieurement à travers la porte (dans laquelle il est ou non inversé, peu importe) les noeuds en question sont chargés ou déchargés à partir d'une valeur initiale, variable, qui dépend de l'historique de l'évolution de l'état des entrées de la porte.

Ce phénomène ayant été identifié selon l'invention comme la cause de l'imprécision du temps de propagation des fronts à travers la porte, l'invention consiste également, bien entendu, à proposer des moyens pour y remédier.

A cet effet, la présente invention concerne une porte OU-Exclusif à quatre entrées complémentaires deux à deux A et NA, et B et NB, et à deux sorties complémentaires XOR et NXOR, dans laquelle deux cellules comportent chacune, connectées en parallèle, deux branches comprenant chacune un premier et un second transistors MOS de type P connectés en série entre une borne d'alimentation supérieure et un noeud de sortie et séparés par un noeud intermédiaire, et, également connectées en parallèle, deux branches comprenant chacune un premier et un second transistors MOS de type N connectés en série entre le noeud de sortie et une borne d'alimentation inférieure et séparés par un noeud intermédiaire ; les grilles de commande des deux transistors de chacune des quatre branches de chaque cellule reçoivent exclusivement l'un des quatre couples d'entrées {A,B}, {NA,B}, {A,NB}, ou {NA,NB} ; les deux branches d'une même cellule qui comportent des transistors du même type reçoivent des couples d'entrées complémentaires deux à deux ; enfin les deux branches d'une cellule déterminée qui comportent des transistors d'un type quelconque, soit type P soit type N, reçoivent respectivement les deux mêmes couples d'entrées que les deux branches de l'autre cellule qui comportent des transistors de l'autre type, soit type N soit type P. Il est en outre connecté, en parallèle sur chaque branche des cellules, une branche qui comporte des transistors de même type, dite branche jumelle de ladite branche, dont le premier et le second transistors reçoivent sur leur grille de commande le couple d'entrées inverse du couple d'entrées reçu par les grilles de commande des transistors de ladite branche. De plus, dans chaque cellule, le noeud intermédiaire d'une quelconque des branches qui comportent des transistors d'un type déterminé, soit type P soit type N, est relié au noeud intermédiaire de la branche jumelle de l'autre branche qui comporte des transistors de même type de la cellule.

Grâce à la combinaison de ces deux dernières caractéristiques, on crée de nouveaux chemins entre les noeuds intermédiaires d'une part, et les noeuds de sortie ou les bornes d'alimentation d'autre part. On constatera à la lumière de la description qui va suivre que ces branches imposent un potentiel à ces noeuds intermédiaires lorsque les transistors de la branche considérée sont non conducteurs. On a ainsi supprimé le caractère flottant de ces noeuds dans cette configuration des signaux d'entrée. En outre, le fonctionnement logique de la porte n'est pas modifié dans la mesure où les nouveaux chemins créés entre, d'une part, le noeud de sortie de chaque cellule et, d'autre part, les bornes d'alimentation supérieure ou inférieure, ne sont jamais passants.

Le noeud de sortie d'une des cellules constitue la sortie XOR de la porte alors que celui de l'autre cellule constitue sa sortie complémentaire NXOR.

D'autres caractéristiques et avantages de la présente invention apparaîtront encore à la lecture de la description qui va suivre. Celle-ci est purement illustrative et doit être lue en regard des dessins annexés sur lesquels on a représenté :
- à la figure 1 : le schéma classique d'un inverseur réalisé en technologie CMOS ;
- à la figure 2 : la table de vérité de la fonction OU-Exclusif à quatre entrées complémentaires deux à deux et à deux sorties complémentaires ;
- à la figure 3 : la structure de base d'une porte OU-Exclusif à quatre entrées complémentaires deux à deux et à deux sorties complémentaires XOR et NXOR (art antérieur) ;
- à la figure 4 : la structure d'une telle porte modifiée de manière à la rendre symétrique (art antérieur) ;
- à la figure 5 : un mode de réalisation d'une porte OU-Exclusif selon l'invention.

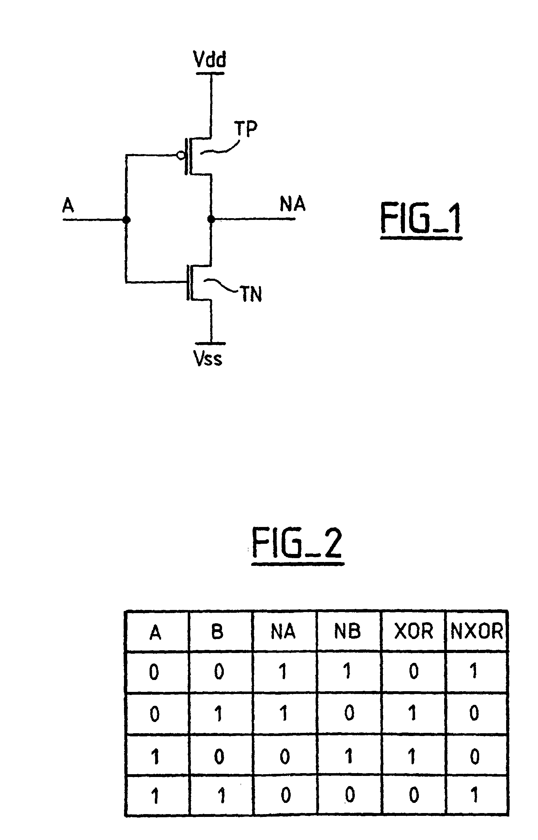

La porte OU-Exclusif selon l'invention est réalisée selon la technologie dite CMOS (Complementary Metal-Oxide Semiconductor). Cette technologie combine l'emploi de transistors MOS de type P et de transistors MOS de type N. La structure de base d'une porte OU-Exclusif réalisée selon la technologie CMOS se déduit aisément de la structure de base d'un inverseur réalisé selon cette technologie (figure 1) d'une part, et de la table de vérité de la fonction OU-Exclusif (figure 2) d'autre part.

A la figure 1, l'inverseur de base réalisé en technologie CMOS comprend un transistor MOS de type P (référencé TP et comportant un petit rond dessiné sur sa grille de commande pour la distinguer d'un transistor de l'autre type) et un transistor MOS de type N (référencé TN) connecté en série entre deux bornes d'alimentation. La source du transistor TP est reliée à une borne d'alimentation supérieure portée à un potentiel Vdd et son drain est relié à un noeud de sortie. La source du transistor TN est reliée à une borne d'alimentation inférieure portée à un potentiel Vss inférieur à Vdd ou à la masse, et son drain est relié au noeud de sortie. Le signal d'entrée A est porté sur les grilles de commande communes de ces deux transistors. Le signal de sortie NA, qui est le complémentaire du signal d'entrée A est disponible sur le noeud de sortie commun aux drains des deux transistors.

Lorsque le signal d'entrée A est à l'état logique 0, le transistor TP est conducteur et le transistor TN est non conducteur. Le noeud de sortie est alors porté au potentiel Vdd de sorte que le signal de sortie NA est à l'état logique 1. A l'inverse, lorsque le signal d'entrée A est à l'état logique 1, le transistor TP est non conducteur et le transistor TN est conducteur. Le noeud de sortie est alors porté au potentiel Vss de sorte que le signal de sortie NA est à l'état logique 0. Lorsque le signal d'entrée est stable, aucun courant ne circule dans les chemins source/drain et drain/source des transistors TP et TN respectivement. La consommation statique est donc nulle. Les transistors ne consomment du courant que pendant les phases de transition d'un état logique à l'autre (la consommation dynamique de la porte est non nulle). Le transistor de type P assure les commutations de la sortie de l'état logique 0 à l'état logique 1 (fronts montants en sortie, ou transition 0-1). Le transistor de type N assure au contraire les commutations de la sortie de l'état logique 1 à l'état logique 0 (fronts descendants en sortie, ou transition 1-0).

Les observations ci-dessus illustrent à la fois l'avantage principal de la technologie CMOS, qui réside dans l'absence de consommation statique en courant, et l'inconvénient inhérent à cette technologie, qui résulte de la différence des performances en courant des transistors qui chargent le noeud de sortie lors des transitions 0-1 d'une part et 1-0 d'autre part. En effet, la mobilité des porteurs du transistor de type N (les électrons) est 2,5 fois supérieure à celle des porteurs du transistor de type P (les trous). Pour des transistors ayant la même largeur de canal, le courant de charge d'un transistor de type N est donc 2,5 fois supérieur à celui d'un transistor de type P. Or ce courant détermine la vitesse de charge des capacités parasites des transistors, notamment de la capacité drain-substrat. D'où il résulte que la transition 0-1 en sortie de l'inverseur est plus lente que la transition 1-0.

A la figure 2, on a représenté la table de vérité de la fonction OU-Exclusif. La valeur de la fonction est donnée pour la variable de sortie XOR en fonction de la valeur logique de deux variables d'entrée A et B distinctes. La table fait également apparaître les valeurs des variables NA, NB et NXOR qui sont les complémentaires respectivement des variables A, B et XOR.

On sait, et il est aisé de le vérifier à l'aide de la table de vérité de la figure 2, que la valeur de la variable de sortie XOR est donnée par l'expression NA*B + A*NB, où le signe * symbolise la fonction logique ET et où le signe + symbolise la fonction logique OU. Symétriquement, on pourra également vérifier que la valeur de la variable de sortie NXOR est donnée par l'expression A*B + NA*NB. Dès lors, on conçoit qu'il est possible de réaliser les fonctions XOR et NXOR à l'aide des signaux A et B et de leurs complémentaires respectifs NA et NB en s'inspirant de la structure de base de l'inverseur en technologie CMOS représenté à la figure 1.

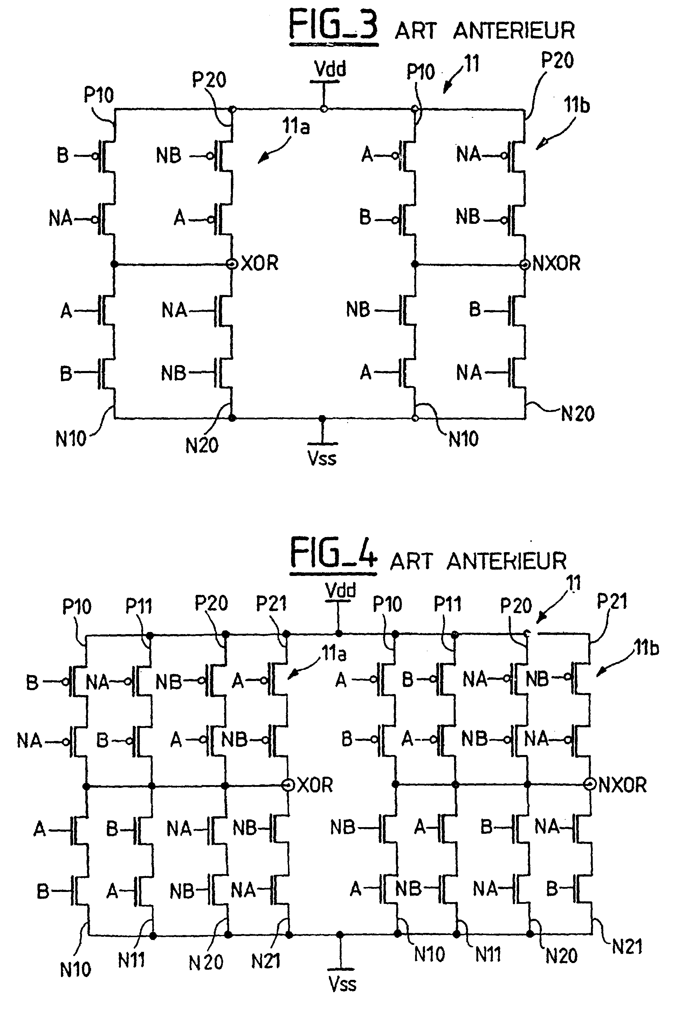

On notera qu'il est avantageux de disposer d'une porte OU-Exclusif à quatre entrées complémentaires deux à deux, c'est-à-dire comprenant deux couples d'entrées complémentaires, A et NA d'une part et B et NB d'autre part, et à deux sorties complémentaires XOR et NXOR. En effet, en se référant maintenant à la figure 3, la porte OU-Exclusif 11 comporte alors deux cellules 11a et 11b de structure identique mais fonctionnant symétriquement pour, l'une, générer la sortie XOR à partir des entrées A, NA, B et NB et, l'autre, générer la sortie complémentaire NXOR à partir des mêmes entrées. Cette identité de structure et cette symétrie dans le fonctionnement contribuent à l'obtention d'un temps de réponse des sorties qui est indépendant du couple d'entrées A et NA ou B et NB qui commute, de la nature de la transition 1-0 ou 0-1 sur celles des sorties XOR ou NXOR que l'on considère, et de l'état logique du couple d'entrées complémentaires qui ne commute pas. La notion de porte symétrique se définit dans le cas d'une porte à quatre entrées complémentaires deux à deux et à deux sorties complémentaires par la caractéristique de triple indépendance du temps de réponse des sorties telle qu'énoncée ci-dessus. En outre la porte OU-Exclusif étant par exemple destinée à être utilisée dans un arbre de portes identiques tel que décrit plus haut, dans lequel des portes sont connectées en cascade, il et avantageux qu'elle génère elle-même sur ses sorties les signaux complémentaires XOR et NXOR qui constituent l'un des couples d'entrées complémentaires d'une porte de la couche suivante dans l'arbre. On évite ainsi le recours à un inverseur pour générer le complémentaire du signal XOR.

La figure 3 représente la structure de base d'une porte OU-Exclusif à quatre entrées complémentaires deux à deux et à deux sorties complémentaires XOR et NXOR selon l'art antérieur illustré par le document EP-A-0 660 525. Chaque cellule 11a et 11b comporte quatre branches: deux branches de type P référencées P10 et P20, ainsi appelées dans la suite car elles comprennent deux transistors MOS de type P connectés en série, qui sont connectées en parallèle entre la borne d'alimentation supérieure et le noeud de sortie de la cellule; et deux branches de type N référencées N10 et N20, ainsi appelées dans la suite car elles comprennent deux transistors MOS de type N connectés en série, qui sont connectées en parallèle entre le noeud de sortie de la cellule et la borne d'alimentation inférieure. Les deux transistors de même type de chaque branche sont séparés par un noeud intermédiaire.

On considère dans la suite que le noeud de sortie de la première cellule 11a délivre la sortie XOR de la porte, alors que le noeud de sortie de la seconde cellule 11B délivre la sortie NXOR de la porte.

Lorsque les deux transistors d'une même branche sont conducteurs, on dit que la branche est conductrice. C'est elle qui impose le potentiel sur le noeud de sortie. On va voir que, quel que soit l'état logique des quatre entrées complémentaires deux à deux, une seule branche par cellule est conductrice à un instant déterminé.

Les grilles de commande des deux transistors de chacune des quatre branches P10, P20, N10, N20 de chaque cellule reçoivent exclusivement l'un des quatre couples d'entrée {A,B}, {NA,B}, {A,NB}, ou {NA,NB}. Par le terme "exclusivement" il faut comprendre que, au sein d'une cellule déterminée, un couple de transistors d'une unique branche reçoit l'un quelconque des quatre couples d'entrées ci-dessus, et que chacun de ces couples d'entrées est affecté aux deux transistors d'une seule des quatre branches de la cellule.

Pour chaque cellule 11a ou 11b, dont la sortie délivre respectivement le signal XOR ou NXOR, les couples d'entrées à porter sur les grilles des transistors de chacune des quatre branches, se conçoivent relativement facilement à partir de la table de vérité de la figure 2 (étant rappelé que cette fonction XOR est donnée par l'expression A*NB + NA*B; étant par ailleurs observé que la mise en série de deux transistors MOS de type P entre la borne d'alimentation supérieure d'une part et le noeud de sortie d'autre part, qui reçoivent sur leurs grilles de commande deux signaux quelconques, génère sur le noeud de sortie le résultat de l'opération ET entre lesdits signaux; et étant enfin observé que la mise en parallèle de deux transistors MOS de type P entre la borne d'alimentation supérieure et le noeud de sortie, recevant deux signaux quelconques sur leurs grilles de commande, génère la fonction ET entre lesdits signaux). Par exemple, pour la cellule 11a délivrant en sortie le signal XOR, on comprend que les deux transistors MOS de type P de la branche P10 reçoivent respectivement les entrées NA et B sur leurs grilles de commande alors que ceux de la branche P20 reçoivent les deux entrées A et NB, les deux transistors de type N de la branche N10 recevant respectivement les deux entrées A et B et ceux de la branche N20 recevant les deux entrées NA et NB. Symétriquement, pour la cellule 11b dont le noeud de sortie délivre la sortie NXOR, les deux transistors de type P de la branche P10 reçoivent les deux entrées A et B sur leurs grilles de commande, alors que ceux de la branche P20 reçoivent les deux entrées NA et NB, les deux transistors de type N de la branche N10 recevant les entrées A et NB et ceux de la branche N20 recevant les deux entrées NA et B.

On peut résumer l'affectation des différents couples d'entrées aux différentes branches d'une cellule déterminée de la porte par l'énoncée des caractéristiques suivantes:
- les grilles de commande des deux transistors de chacune des quatre branches de chaque cellule reçoivent exclusivement l'un des quatre couples d'entrées {A,B}, {NA,B}, {A,NB} ou {NA,NB};
- les deux branches d'une même cellule qui sont du même type (les branches P10 et P20 de type P, ou les branches N10 et N20 de type N) reçoivent des couples d'entrée complémentaires deux à deux (à titre d'exemple le couple {B,NA} et le couple {NB,A} pour les branches de type P de la première cellule 11a);
- les deux branches d'un type quelconque (par exemple de type P) d'une cellule déterminée (par exemple la cellule 11a) reçoivent respectivement les deux même couples d'entrée que les deux branches de l'autre cellule (la cellule 11b) qui sont de l'autre type (de type N).

Cette structure de base d'une porte exclusive à quatre entrées complémentaires deux à deux et à deux sorties complémentaires a déjà été améliorée dans l'art antérieur de manière à rendre la structure de la porte symétrique d'un point de vue électrique (voir EP-A-0 660 525).

L'amélioration provient de la modification de la structure de la porte qui consiste à connecter, en parallèle sur chaque branche de la porte, une autre branche du même type, dite branche jumelle de ladite branche, dont les transistors reçoivent sur leur grille de commande le couple inverse du couple d'entrées reçu par la grille de commande des transistors de ladite branche. Le couple inverse d'un couple d'entrées quelconque {X,Y} se définit comme le couple {Y,X}. La notion de couple d'entrées est donc une notion faisant appel à une relation d'ordre entre lesdites entrées. Plus simplement on exprimera cette notion en soulignant qu'elle signifie que si au sein d'une branche déterminée le premier transistor, situé du côté de la borne d'alimentation, et le second transistor, situé du côté du noeud de sortie, reçoivent le couple d'entrées {X,Y} c'est-à-dire respectivement l'entrée X pour le premier et l'entrée Y pour le second, alors, au sein de la branche jumelle de ladite branche, le premier transistor, situé du côté de la borne d'alimentation, et le second transistor, situé du côté du noeud de sortie, reçoivent le couple inverse {X,Y}, c'est-à-dire, respectivement l'entrée Y pour le premier et l'entrée X pour le second. Ainsi, à la figure 4 conforme à cet art antérieur, une branche jumelle P11 est mise en parallèle sur la branche P10 de chaque cellule 11a ou 11b, une branche jumelle P21 étant mise en parallèle sur la branche P20, alors qu'une branche jumelle N11 est mise en parallèle sur la branche N10 et qu'une branche N21 est mise en parallèle sur la branche N20, les deux transistors de chaque branche jumelle recevant le couple inverse du couple d'entrées reçu par les transistors de chacune des branches auxquelles elles sont associées.

Cette disposition permet d'égaliser l'impédance vue par chaque entrée A, NA, B ou NB d'un point de vue dynamique. En effet, au sein de chaque cellule 11a ou 11b, l'impédance vue par chaque entrée est l'impédance équivalente d'un transistor de type P (celui proche de la borne d'alimentation supérieure) en parallèle avec deux transistors de type P en série, le tout en parallèle avec l'impédance d'un transistor de type N, (celui proche de la borne d'alimentation inférieure) en parallèle avec deux transistors de type N. Pour plus de détails sur les effets des branches jumelles sur la symétrisation de l'impédance vue par chaque entrée de la porte, on pourra se référer au document EP-A-0 660 125.

Sans cesser d'exercer leur fonction d'égalisation d'impédance décrite ci-dessus, les branches jumelles sont agencées selon l'invention de manière à remplir une nouvelle fonction qui permet de supprimer le caractère flottant que peut présenter le noeud intermédiaire de chacune des branches.

Ce caractère flottant de certains noeuds intermédiaires peut être mise en évidence en considérant à nouveau la figure 3 plus dépouillée et donc plus facile à commenter que la figure 4. Pour cet exposé, on ne considérera que la cellule lla. Supposons qu'à un instant donné l'entrée A ait la valeur logique 0 de même que l'entrée B. Les entrées NA et NB ont donc toutes les deux la valeur logique 1. Par conséquent, c'est la branche N20 de type N dont les transistors reçoivent respectivement les entrées NA et NB qui est conductrice et qui impose l'état du noeud de sortie. Le potentiel sur le noeud de sortie XOR est en effet sensiblement égal au potentiel Vss. Le potentiel sur le noeud intermédiaire de la branche N20 est sensiblement égal au potentiel Vss. Les deux transistors de la branche N10 adjacente à la branche N20 qui est conductrice, sont non conducteurs comme recevant sur leur grille de commande des signaux à l'état logique 0. Le noeud intermédiaire de la branche 10 est donc flottant. Dans la branche P10 de type P le transistor proche de la borne d'alimentation supérieure qui reçoit l'entrée B est conducteur en sorte que le potentiel sur le noeud intermédiaire de cette branche est sensiblement égal au potentiel Vdd. A l'inverse, dans l'autre branche P20 de type P, c'est le transistor proche du noeud de sortie recevant l'entrée A qui est conductrice, en sorte que le potentiel du noeud intermédiaire de ladite branche est sensiblement égal au potentiel du noeud de sortie de la cellule, en l'occurrence un potentiel proche de Vss. On notera ainsi que seul le noeud intermédiaire de la branche N10 adjacente à la branche N20 qui conduit, est un noeud flottant, les autres noeuds étant portés à des potentiels déterminés. Le potentiel sur le noeud intermédiaire de la branche N10 a une valeur initiale dépendant de l'état antérieur des quatres entrées A, NA, B et NB. Le potentiel sur le noeud intermédiaire de la branche N10, n'est maintenu que par l'action des capacités parasites des transistors, et notamment de la capacité drain/substrat (le substrat étant porté au potentiel Vss pour les transistors de type N et au potentiel Vdd pour les transistors de type P). A supposer que les entrées restent dans la configuration envisagée pendant une durée suffisante, ce potentiel va chuter du fait des courants de fuite. Ainsi, lorsque l'une des deux entrées A ou B repassera à l'état logique 1, en sorte que l'un des deux transistors de la branche N10 se mettra à conduire, le noeud intermédiaire devra être chargé à un potentiel proche de Vdd (si c'est l'entrée A qui est passée à l'état logique 1) ou déchargé à un potentiel proche de Vss (si c'est l'entrée B qui est repassée à l'état logique 1) à partir d'un potentiel initial dont la valeur dépendra de la durée (indéterminée) pendant laquelle les deux entrées A et B sont restées à l'état logique 0. Ainsi, le temps nécessaire pour charger ou décharger le noeud intermédiaire de la branche N10 est-il variable selon l'historique de l'évolution de l'état logique des entrées. Puis, éventuellement, lorsque l'autre entrée repassera également à l'état logique 1 en sorte que la branche N10 deviendra conductrice, c'est alors le potentiel sur le noeud de sortie qui partira d'une valeur indéterminée. Ceci implique donc des différences dans le temps de commutation de la sortie XOR de la porte, selon l'historique de l'évolution de l'état logique des entrées. Il est bien évident que ce phénomène n'intervient que pour des valeurs élevées (quelques gigabits par seconde) du débit des données qui traversent la porte.

Selon l'invention, des moyens permettant d'imposer en toutes circonstances un potentiel sur les noeuds intermédiaires de chaque branche sont proposés. Ces moyens comprennent les branches jumelles décrites ci-dessus en regard de la figure 4, mais agencées d'une manière nouvelle leur permettant de remplir une nouvelle fonction, autre que celle d'égalisation de l'impédance vue par chacune des entrées. Cet agencement conforme à l'invention est visible à la figure 5. Dans chaque cellule, le noeud intermédiaire d'une quelconque des branches d'un type déterminé (type P ou type N) est relié au noeud intermédiaire de la branche jumelle de l'autre branche du même type de la même cellule. Par exemple, le noeud intermédiaire de la branche P10 de type P est relié au noeud intermédiaire de la branche jumelle P21 de l'autre branche P20 de type P de la cellule. Egalement le noeud intermédiaire de la branche P20 de type P est relié au noeud intermédiaire de la branche jumelle P11 de l'autre branche P10 de type P de la cellule. De la même manière, le noeud intermédiaire de la branche N10 de type N est relié au noeud intermédiaire de la branche jumelle N21 de l'autre branche N20 de type N de la cellule. Et enfin le noeud intermédiaire de la branche N20 de type N est relié au noeud intermédiaire de la branche jumelle N11 de l'autre branche N10 de type N de la cellule.

On a ainsi crée quatre nouveaux chemins entre les bornes d'alimentation et le noeud de sortie de la cellule. L'effet produit par ces connexions est d'imposer un potentiel sur le noeud intermédiaire de la branche adjacente à celle des quatre branches de la cellule qui est conductrice selon l'état logique des quatre entrées. Ainsi, si l'on reprend l'exemple considéré ci-dessus afin de mettre en évidence le caractère flottant de ce noeud intermédiaire dans lequel les entrées A et B étaient à l'état logique 0 en sorte que le noeud intermédiaire de la branche N10 de la cellule 11a était flottant, on constate que le potentiel à ce noeud intermédiaire est dorénavant imposé par le potentiel du noeud intermédiaire de la branche N21, cette dernière étant conductrice du fait que ses transistors reçoivent sur leur grille de commande le couple d'entrées {NA,NB} qui sont à l'état logique 1. Ce noeud intermédiaire est on l'occurrence porté à un potentiel sensiblement égal à Vss, en sorte que le noeud intermédiaire de la branche N10 est déchargé au potentiel Vss. Plus généralement, on peut montrer que l'effet des connexions entre le noeud intermédiaire d'une branche d'un type donné et le noeud intermédiaire de la branche jumelle de l'autre branche du même type de la même cellule, est de décharger la capacité parasite drain/substrat du transistor de la branche adjacente à la branche conductrice qui est proche de la borne d'alimentation. En effet, pour les branches de type P cette capacité relie la borne d'alimentation supérieure et le noeud intermédiaire alors que, pour les branches de type N, elle relie la borne d'alimentation inférieure et le noeud intermédiaire.

On observera que les huit nouveaux chemins créés au sein de chaque cellule entre les bornes d'alimentation et le noeud de sortie, n'influencent pas le fonctionnement logique ou électrique de la porte dans la mesure où chacun de ces nouveaux chemins comporte deux transistors recevant sur leur grille de commande respectivement une des quatre entrées et son entrée complémentaire. Ainsi par exemple, toujours pour la cellule 11a, le transistor de type N de la branche N10 qui se situe du côté du noeud de sortie reçoit l'entrée A alors que le transistor de type N de la branche N21 situé du côté de la borne d'alimentation inférieure reçoit l'entrée NA, de sorte que le chemin créé entre le noeud de sortie XOR et la borne d'alimentation inférieure à travers ces deux transistors n'est jamais conducteur.

Selon un autre avantage, l'impédance vue par chacune des quatre entrées est toujours identique, bien que de valeur différente de celle vue par les quatre entrées de la porte de la figure 4 de l'art antérieur.

Selon une autre caractéristique de l'invention, la porte OU-Exclusif étant réalisée dans un unique circuit intégré en technologie CMOS, la largeur du canal des transistors de type P est 2,5 fois supérieure à la largeur du canal des transistors de type N. De la sorte, on compense la faiblesse du courant de charge des transistors de type P par rapport à celle du courant de charge des transistors de type N, due à la différence de mobilité des porteurs de charge dans l'un et l'autre type de transistor. Cette disposition est prévue de manière à ce que les deux sorties XOR et NXOR de la porte 11 commutent symétriquement sensiblement simultanément. Ceci est particulièrement avantageux lorsque la porte OU-Exclusif est destinée à être utilisée dans un arbre de portes identiques.

L'invention concerne également un multiplieur de fréquence du type présenté en introduction de la présente description, dans lequel l'arbre de portes OU-Exclusif est réalisé avec des portes conformes à la figure 5. On notera qu'il est nécessaire de générer les signaux complémentaires logiques des signaux échantillonnés qui sont appliqués en entrée des portes OU-Exclusif de la première couche de l'arbre. Ces signaux complémentaires sont également reçus par les entrées de l'arbre. Un moyen pour générer ces signaux complémentaires sans introduire de retard entre la commutation d'un signal et celle de son signal complémentaire est par exemple décrit dans le document EP-A-0 660 525.

Grâce à l'invention, les temps de propagation des fronts à travers l'arbre de portes Ou-Exclusif sont égalisés, quelque soit l'évolution de l'état logique des entrées, avec une précision de l'ordre de deux picosecondes. L'invention procure donc un résultat substantiel qui a pu être vérifié.

## Revendications

1. Porte OU-Exclusif à quatre entrées complémentaires deux à deux (A et NA, et B et NB), et à deux sorties complémentaires (XOR et NXOR), dans laquelle deux cellules (11a-11b) comportent chacune, connectées en parallèle, deux branches (P10, P20) comprenant chacune un premier et un second transistors MOS de type P connectés en série entre une borne d'alimentation supérieure et un noeud de sortie (XOR ou NXOR) et séparés par un noeud intermédiaire, et, également connectées en parallèle, deux branches (N10, N20) comprenant chacune un premier et un second transistors MOS de type N connectés en série entre le noeud de sortie et une borne d'alimentation inférieure et séparés par un noeud intermédiaire ;
les grilles de commande des deux transistors de chacune des quatre branches de chaque cellule recevant exclusivement l'un des quatre couples d'entrées ({A,B}, {NA,B}, {A,NB}, ou {NA,NB});
les deux branches d'une même cellule qui comportent des transistors du même type reçoivent des couples d'entrées complémentaires deux à deux ;
les deux branches d'une cellule déteminée d'un type quelconque, soit type P soit type N, reçoivent respectivement les deux mêmes couples d'entrées que les deux branches de l'autre cellule qui comportent des transistors de l'autre type, soit type N soit type P,
**caractérisé en ce que**, en parallèle sur chaque branche (P10, P20, N10, et N20), est en outre connectée une branche qui comporte des transistors de même type, dite branche jumelle (respectivement P11, P21, N11, et N21) de ladite branche, dont le premier et le second transistors reçoivent sur leur grille de commande le couple d'entrées inverse du couple d'entrées reçu par les grilles de commande des transistors de ladite branche ;
et **en ce que**, dans chaque cellule, le noeud intermédiaire d'une quelconque des branches qui comportent des transistors d'un type déterminé, soit type P soit type N, est relié au noeud intermédiaire de la branche jumelle de l'autre branche qui comporte des transistors de même type.

2. Porte OU-Exclusif selon la revendication 1, **caractérisée en ce que** la largeur de canal des transistors MOS de type P est 2,5 fois plus grande que celle des transistors MOS de type N.

3. Multiplieur de fréquence du type comprenant une chaîne de N circuits à retard pour générer N signaux d'échantillonnage déphasés dans le temps à partir d'un signal d'horloge de fréquence déterminée fo, des moyens d'échantillonnage d'un mot de N bits d'information à transmettre se présentant en série à l'aide desdits N signaux d'échantillonnage qui produisent N signaux échantillonnés, et un arbre de portes OU-Exclusif à quatre entrées complémentaires deux à deux et à deux sorties complémentaires recevant sur ses entrées lesdits N signaux échantillonnés et leurs complémentaires logiques,
**caractérisé en ce que** les portes OU-Exclusif de l'arbre sont des portes OU-Exclusif selon l'une des revendications 1 ou 2.

## Patentansprüche

1. Exklusiv-ODER-Gatter mit vier Eingänge, die jeweils paarweise komplementär sind (A und NA, und B und NB) und mit zwei komplementären Ausgängen (XOR und NXOR), in dem zwei Zellen (11a-11b) jeweils parallel geschaltet zwei Zweige (P10, P20) umfassen, die jeweils einen ersten und einen zweiten MOS-Transistor des P-Typs aufweisen, die zwischen einem oberen Versorgüngsanschluß und einem Ausgangsknoten (XOR oder NXOR) in Reihe geschaltet und durch einen Zwischenknoten getrennt sind, und auch jeweils zwei parallel geschaltete Zweige (N10, N20) umfassen, die jeweils einen ersten und einen zweiten MOS-Transistor des N-Typs aufweisen, welche zwischen dem Ausgangsknoten und einem unteren Versorgungsanschluß in Reihe geschaltet und durch einen Zwischenknoten getrennt sind;
wobei die Steuergates der zwei Transistoren jedes der vier Zweige jeder Zelle exklusiv eines der vier Eingangspaare empfangen ({A, B}, {NA, B}, {A, NB}oder {NA, NB});
wobei die beiden Zweige ein und derselben Zelle, welche Transistoren des gleichen Typs umfaßt, paarweise komplementäre Eingangspaare empfangen;
wobei die zwei Zweige einer bestimmten Zelle egal welchen Typs, sei es P oder N, jeweils die zwei gleichen Eingangspaare wie die zwei Zweige der anderen Zelle des anderen Typs, welche Transistoren umfaßt, sei es N oder P, empfangen;
**dadurch gekennzeichnet, daß** zu jedem Zweig (P10, P20, N10 und N20) femer ein Zweig des gleichen Typs, der Transistoren umfaßt und Gabelzweig (P11, P21, N11 bzw. N21) dieses Zweigs genannt wird, parallel geschaltet ist, wobei der erste und der zweite Transistor an ihrem Steuergate das Eingangspaar empfängt, das zu dem Eingangspaar an den Steuergates der Transistoren dieses Zweigs invers ist;
und daß in jeder Zelle der Zwischenknoten eines beliebigen Zweigs eines bestimmten Typs, der Transistoren umfaßt, sei es N oder P, mit einem Zwischenknoten des Gabelzweigs des anderen Zweigs desselben Typs, der Transistoren umfaßt, verbunden ist.

2. Exklusiv-ODER-Gatter nach Anspruch 1, **dadurch gekennzeichnet, daß** die Größe des Kanals der MOS-Transistoren des P-Typs 2,5 mal größer ist als die der MOS-Transistoren des N-Typs.

3. Frequenzmultiplizierer mit einer Kette aus N Verzögerungsschaltkreisen zum Erzeugen von N zeitlich phasenverschobenen Abtastsignalen ausgehend von einem Taktsignal mit vorgegebener Frequenz fo, mit Mitteln zum Abtasten eines N-Bitwortes, das zu übertragende Information darstellt und sich mit Hilfe der N Abtastsignalen, welche N abgetastete Signale erzeugen, seriell darstellt, und einem Exklusiv-ODER-Gatterbaum mit vier paarweise komplementären Eingängen und zwei komplementären Ausgängen, die an ihren Eingängen die N abgetasteten Signale und deren logische Komplemente empfangen,
**dadurch gekennzeichnet, daß** die Exklusiv-ODER-Gatter des Baums Exklusiv-ODER-Gatter gemäß einem der Ansprüche 1 oder 2 sind.

## Claims

1. Exclusive OR gate with four two by two complementary inputs (A and NA, and B and NB), and two complementary outputs (XOR and NXOR), in which two cells (11a-11b) each comprise, connected in parallel, two branches (P10, P20) each comprising a first and a second MOS transistor of type P connected in series between an upper supply terminal and an output node (XOR or NXOR) and separated by an intermediate node, and, also connected in parallel, two branches (N10, N20) each comprising a first and a second MOS transistor of type N connected in series between the output node and a lower supply terminal and separated by an intermediate node;
the control grids of the two transistors of each of the four branches of each cell receiving exclusively one of the four pairs of inputs ({A,B}, {NA,B}, {A,NB}, or {NA, NB}) ;
the two branches of one and the same cell which comprise transistors of the same type receiving pairs of two by two complementary inputs;
the two branches of a given cell of any one type, either type P or type N, receiving respectively the same two pairs of inputs as the two branches of the other cell which comprise transistors of the other type, either type P or type N;
**characterised in that** in parallel each branch (P10, P20, N10, and N20) is additionally connected to a branch which comprises transistors of the same type, referred to as the twin branch (respectively P11, P21, N11, and N21) of said branch, the first and the second transistors of which receive at their control grid the reverse pair of inputs to the pair of inputs received by the control grids of the transistors of said branch;
and **in that** in each cell the intermediate node of any one of the branches which comprise transistors of a given type, either type P or type N, is connected to the intermediate node of the twin branch of the other branch which comprises transistors of the same type.

2. Exclusive OR gate according to claim 1,
**characterised in that** the channel width of the MOS transistors of type P is 2.5 times greater than that of the MOS transistors of type N.

3. Frequency multiplier of the type comprising a chain of N delay circuits to generate N sampling signals out of phase in time from a clock signal of given frequency fo, sampling means for a word of N bits of information to be transmitted presenting themselves in series with the aid of said N sampling signals which produce N sampled signals, and a tree of exclusive OR gates with four two by two complementary inputs and two complementary outputs receiving at its inputs said N sampled signals and their logical complements, **characterised in that** the exclusive OR gates of the tree are exclusive OR gates according to one of claims 1 or 2.
